# EUROPÄISCHE PATENTSCHRIFT

(11) **EP 1 848 015 B1**
(45) Veröffentlichungstag und Bekanntmachung des Hinweises auf die Patenterteilung: **09.12.2009**
(21) Anmeldenummer: 07001270.3
(22) Anmeldetag: 22.01.2007
(51) Int. Cl.: H01H 9/02, H01H 9/18, H01H 13/70

(54) **Elektrisches/elektronisches Installationsgerät**
Electric/electronic installation device
Appareil d'installation électrique/élect

(30) Priorität: 22.04.2006 DE 102006018796
(43) Veröffentlichungstag der Anmeldung: 24.10.2007
(73) Patentinhaber: Albrecht Jung GmbH & Co. KG, 58579 Schalksmühle (DE)
(72) Erfinder: Gebhardt, Marc, Dipl.-Ing., 58579 Schalksmühle (DE); Ullrich, Konrad, Dipl.-Ing., 58339 Breckerfeld (DE)

(56) Entgegenhaltungen:
- EP-A- 1 635 368
- EP-A- 1 635 434
- DE-A1- 10 324 579
- US-A- 4 501 937
- US-A- 5 579 002

## Beschreibung

Die vorliegende Erfindung geht von einem gemäß Oberbegriff des Hauptanspruches konzipierten elektrischen/elektronischen Installationsgerät aus.

Derartige elektrische/elektronische Installationsgeräte sind in der Regel dafür vorgesehen, eine Vielzahl von in Gebäuden installierten Aktoren (Jalousieantriebe, Beleuchtungseinrichtungen, Fühler, Wächter usw.) bedarfsgerecht zu beeinflussen. Zu diesem Zweck sind die unterschiedlichsten Installationseinrichtungen, wie Schalter, Taster, Dimmer usw. bekannt geworden.

Durch die EP 1 635 434 A1 und die EP 1 635 368 A2 sind jeweils dem Oberbegriff des Hauptanspruches entsprechende elektrische/elektronische Installationsgeräte für die Gebäudesystemtechnik bekannt geworden. Bei diesen elektrischen/elektronischen Installationsgeräten für die Gebäudesystemtechnik ist eine erste Leiterplatte vorgesehen, auf dessen Oberseite alle zur Bedienung notwendigen Funktionselemente angeordnet sind, wobei auf der Unterseite ein- und derselben ersten Leiterplatte sowohl die für die jeweilige Applikation notwendigen, als auch ein erster Teil der für den Betrieb in einem Bussystem notwendigen Funktionsbauteile angeordnet sind, und wobei die erste Leiterplatte elektrisch leitend mit einer zweiten Leiterplatte in Verbindung steht, auf welcher der zweite Teil der für den Betrieb im Bussystem notwenigen Funktionsbauteile angeordnet sind, und wobei der Oberseite der ersten Leiterplatte eine Anzeigeeinrichtung zugeordnet ist. Die zur Verfügung gestellte Nutzfläche hinsichtlich der Bestückung mit Funktionselementen, Anzeigeeinrichtungen und Betätigungstasten bleibt bei diesen elektrischen/elektronischen Installationsgeräten jedoch auf die Fläche beschränkt, die normalerweise zur Verfügung steht.

Des weiteren ist durch die DE 40 00 623 A1 ein elektrisches/elektronisches Installationsgerät für die Gebäudesystemtechnik bekannt geworden, bei welchem eine Leiterplatte vorgesehen ist, auf dessen Oberseite alle zur Bedienung der zugeordneten Aktoren notwendigen Funktionselemente angeordnet sind. Außerdem weist dieses elektrische/elektronische Installationsgerät eine separate Funktionsbaugruppe auf, welche über eine Steckverbindung mit der Unterseite der elektrischen Leiterplatte verbindbar ist. Diese Funktionsbaugruppe weist alle für den Betrieb in einem Bussystem notwendigen Funktionsbauteile auf. Eine solche Ausbildung eines elektrischen/elektronischen Installationsgerät hat jedoch nicht nur einen beachtlichen Raumbedarf in der Installationsdose zur Folge und ist daher vergleichsweise aufwendig bei seiner Installation im Gebäude, sondern weist ein solches elektrisches/elektronisches Installationsgerät zudem eine geringe Variabilität hinsichtlich der Anpassungsmöglichkeiten an die Verwendung verschiedener Applikationen auf und ist auch nur mit einer vergleichsweise kleinen Nutzfläche zur Anordnung von zur Bedienung und Anzeige notwendigen Funktionselementen ausgestattet.

Zudem ist durch die US 5,579,002 eine Fernbedienung bekannt geworden, die mehrere Betätigungstasten aufweist, wobei deren zugehörige Schaltelemente einstückige Bestandteile einer Domschaltmatte sind.

Außerdem ist durch die DE 103 24 579 A1 eine Bedienvorrichtung bekannt geworden, die zur Steuerung ein berührungsempfindliches Bedienfeld umfasst, auf welchem zwei Oberflächenformen darstellbar sind.

Zudem ist durch die US 4,501,937 eine, mehrere Betätigungstasten aufweisende Schaltereinheit bekannt geworden, welche den Betätigungstasten zugeordnete Anzeigeeinheiten aufweist.

Ausgehend von derart ausgebildeten elektrischen/elektronischen Installationsgeräten liegt der vorliegenden Erfindung die Aufgabe zugrunde, ein Installationsgerät zu schaffen, das nicht nur hinsichtlich seines in die Installationsdose hineinragenden Bereiches besonders kompakt ausgeführt ist und somit bei seiner Installation eine besonders einfache und kostengünstige Handhabung ermöglicht, sondern darüber hinaus hinsichtlich der Verwendung verschiedener Applikationen besonders variabel ausgestaltet ist und ohne das Design zu beeinträchtigen eine extrem große Nutzfläche zur Anordnung von zur Bedienung notwendigen Funktionselementen sowie einer Anzeigeeinrichtung zur Verfügung stellt.

Erfindungsgemäß wird diese Aufgabe durch die im Hauptanspruch angegebenen Merkmale gelöst.

Bei einer solchen Ausbildung ist besonders vorteilhaft, dass durch die matrixartige Anordnung der Funktionselemente auf der Oberseite der ersten Leiterplatte besonders flexible Auswahlmöglichkeiten hinsichtlich der Bestückung mit verschiedenartig ausgeführten Bedienelementen bestehen und zudem durch die Verwendung einer zweiten Leiterplatte je nach Bedarf Anzeigeeinrichtungen, sensorische Anordnungen, wie Wächter usw. auf besonders einfache Art und Weise eingebunden werden können. Außerdem ist besonders vorteilhaft, dass eine große Designfreiheit dadurch gegeben ist, weil die Leiterplatte mit ihren Bedienelementen in Bezug auf die Wandebene nur relativ geringfügig aufträgt. Zudem ist besonders vorteilhaft, dass sich schon durch die geschickte Ausnutzung des zur Verfügung stehenden Bauraums eine große Nutzfläche zur Anordnung von zur Bedienung notwendigen Funktionselementen sowie einer Anzeigeeinrichtung ergibt.

Eine extrem große Nutzfläche lässt sich auf einfache Art und Weise realisieren, indem sowohl die erste Leiterplatte, als auch das die erste Leiterplatte aufnehmende Gehäuse an zumindest einer Seite jeweils als Fortsatz weitergeführt ist. Weil das Gehäuse besonders dünne Wandstärken aufweist, kann dieses, ohne das Design zu beeinträchtigen mit der ebenen Unterseite seines Fortsatz direkt auf der Wandfläche zur Anlage kommen.

Weitere vorteilhafte Ausgestaltungen des erfindungsgemäßen Gegenstandes sind in den Unteransprüchen angegeben. Anhand eines Ausführungsbeispiels sei der erfindungsgemäße Gegenstand im Prinzip näher erläutert, dabei zeigt:
- Fig. 1:: prinziphaft ein solches elektrisches/elektronisches Installationsgerät in Explosionsdarstellung;
- Fig. 2:: prinziphaft ein solches elektrisches/elektronisches Installationsgerät in Zuordnung zu einem Abdeckrahmen und einer mit einem Tragring versehenen Installationsdose.

Wie aus den Figuren hervorgeht, besteht ein solches elektrisches/elektronisches Installationsgerät für die Gebäudesystemtechnik hauptsächlich aus einer ersten Leiterplatte L1 und einer zweiten Leiterplatte L2, die von einem gemeinsamen Gehäuse 2 aufgenommen sind. Das Gehäuse 2 ist mit einem Tragring 3 umgeben. Über den Tragring 3 wird das elektrische/elektronische Installationsgerät an einer normalen, d. h. übliche Abmessungen aufweisende Installationsdose D festgelegt. Der Oberseite der ersten Leiterplatte L1 sind alle zur Bedienung der angeschlossenen Aktoren notwendigen Funktionselemente zugeordnet. Die Unterseite der ersten Leiterplatte L1 weist sowohl die für die jeweilige Applikation notwendigen, als auch den ersten Teil der für den Betrieb in einem Bussystem notwendigen Funktionsbauteile 4 auf. Auf der mit der ersten Leiterplatte L1 elektrisch leitend in Verbindung stehenden zweiten Leiterplatte L2 ist der zweite Teil der für den Betrieb in einem Bussystem notwendigen Funktionsbauteile 4 angeordnet. Außerdem steht die zweite Leiterplatte L2 mit einer Anzeigeeinrichtung LCM in Verbindung.

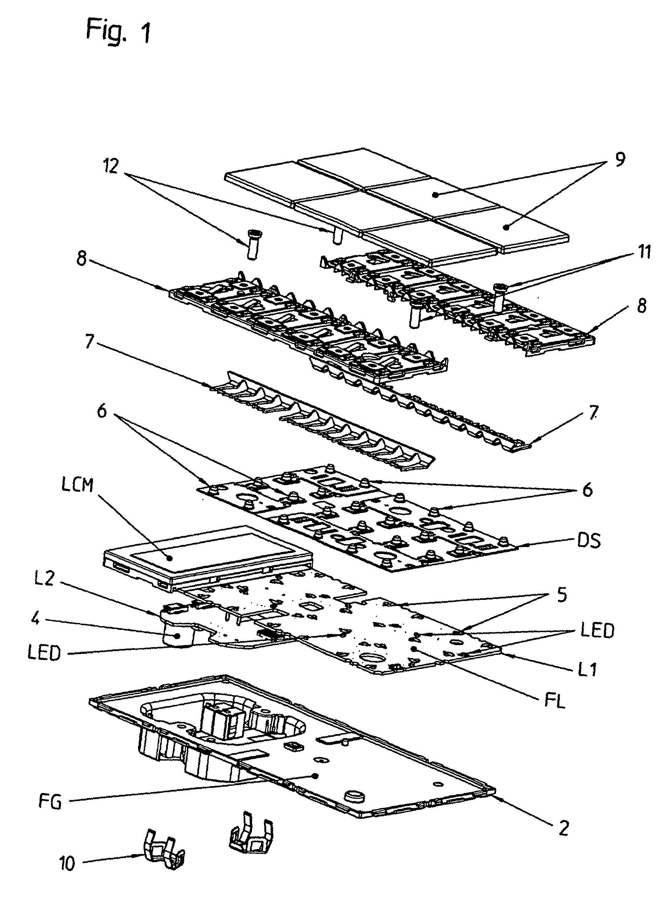

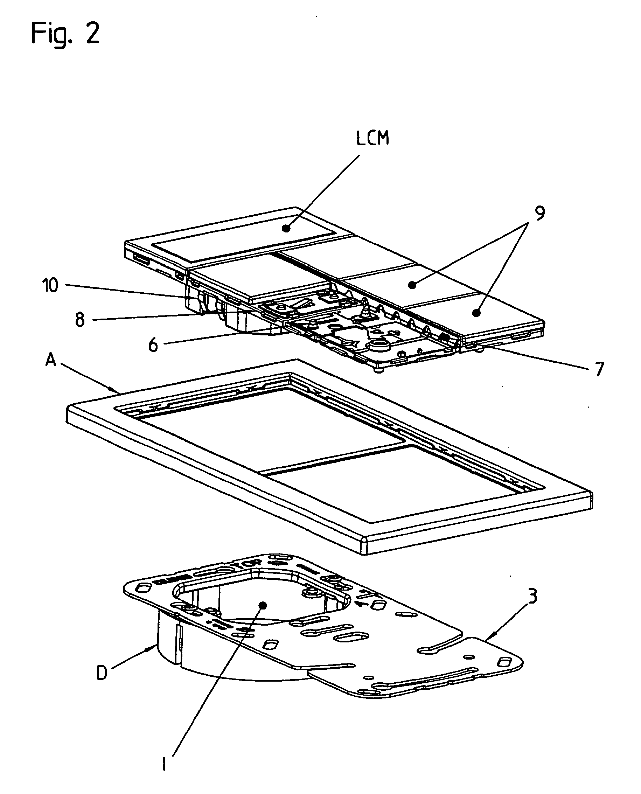

Wie des weiteren insbesondere aus Figur 1 hervorgeht, sind die Schaltflächen 5 der zur Bedienung notwendigen Schaltelemente 6 matrixartig auf der Oberseite der ersten Leiterplatte L1 angeordnet. Alle Schaltelemente 6 sind einstückig Bestandteil einer sogenannten Domschaltmatte DS, die mit ihrer Unterseite auf der Oberseite der ersten Leiterplatte L1 zur Anlage kommt. Jeder auf der Oberseite der ersten Leiterplatte L1 vorhandenen Schaltfläche 5 ist ein als Leuchtdiode LED ausgebildetes Funktionselement zugeordnet. Die Domschaltmatte DS weist Aussparungen auf, so dass die Leuchtdioden LED ihr Licht ohne Beeinträchtigungen in zwei der Oberseite der ersten Leiterplatte L1 zugeordnete Lichtleitkörper 7 einkoppeln können. Oberhalb der beiden Lichtleitkörper 7 und der Domschaltmatte DS sind zwei Halteplatten 8 angeordnet. Zur sicheren Festlegung werden die beiden Halteplatten 8 über miteinander in Wirkverbindung kommende Rastmittel am Gehäuse 2 sowie am Gehäuse der Anzeigeeinrichtung LCM festgelegt. Somit liegt, wie insbesondere aus Figur 2 hervorgeht, eine Montagebaugruppe vor, die aus dem Gehäuse 2, der ersten Leiterplatte L1, der zweiten Leiterplatte L2 mit Anzeigeeinrichtung LCM, der Domschaltmatte DS, zwei Lichtleitkörpern 7 und zwei Halteplatten 8 besteht. Zur Komplettierung brauchen jetzt nur noch die zur Bedienung der angeschlossenen Aktoren notwendigen Betätigungstasten 9 auf die Halteplatte 8 aufgesetzt werden. Die Betätigungstasten 9 sind über entsprechende Haltemittel beweglich zur Betätigung der zugeordneten Schaltelemente 6 an den beiden Halteplatten 8 angebracht. Die beiden Halteplatten 8 sind zudem zur Fixierung der Domschaltmatte DS und der beiden Lichtleitkörper 7 vorgesehen. Die Anzeigeeinrichtung LCM ist als Flüssigkeitskristallmodul ausgebildet und wird über miteinander in Wirkverbindung kommende Rastelemente samt der zweiten Leiterplatte L2 und der ersten Leiterplatte L1 am Gehäuse 2 festgelegt. Über Flexleiter steht die erste Leiterplatte L2 mit der zweiten Leiterplatte L2 in Verbindung. Die Anzeigeeinrichtung LCM kann bei Bedarf berührungsempfindlich ausgeführt sein, so dass über entsprechend variabel darstellbare Funktionsfelder z. B. die Beeinflussung von angeschlossenen Aktoren vorgenommen werden kann. Auch ist es möglich, eine weitere sensorische Funktionseinheit, wie z. B. einen Bewegungsmelder bei Bedarf auf der ersten Leiterplatte L1 oder der zweiten Leiterplatte L2 anzuordnen. Besteht die Notwendigkeit kann auch die Unterseite der ersten Leiterplatte L1 mit Funktionsbauteilen, wie z. B. einem Speicher für die Anwendungssoftware, einem Steckanschluss usw. bestückt werden.

Wie des weiteren aus den Figuren hervorgeht, ist das Gehäuse 2 zum Zwecke einer besonders einfachen Installation des elektrischen/elektronischen Installationsgerätes mit zwei Haltefedern 10 bestückt, die am Ende des Installationsvorganges rastend hinter entsprechende Haltezonen des Tragrings 3 greifen. Der untere Teil des Gehäuses 2, welcher die erste Leiterplatte L1 mit ihren auf der Unterseite angeordneten Funktionsbauteilen und die Unterseite der zweiten Leiterplatte L2 umgibt, weist zur einfachen Installation derartige Außenabmessungen auf, so dass die Einführung in den Innenraum I einer normalen Installationsdose D möglich ist. Um eine besonders große Nutzfläche zur Anordnung einer Anzeigeeinrichtung LCM und mehreren großflächigen Betätigungstasten 9 zu schaffen, ist die erste Leiterplatte L1 und ist das die erste Leiterplatte L1 aufnehmende Gehäuse 2 an einer Seite jeweils mit einem Fortsatz FL, FG versehen. Sowohl an das Gehäuse 2 ist dessen Fortsatz FG, als auch an die erste Leiterplatte L1 ist deren Fortsatz FL einstückig angeformt. Nach Fertigstellung der Installation kommt das Gehäuse 2 unter Zwischenschaltung eines ebenfalls einen einstückigen Fortsatz FT aufweisenden Tragring 3 mit der ebenen Unterseite seines Fortsatz FG auf der Wandfläche der die Installationsdose D aufnehmenden Wand zur Anlage. Weil sowohl das Gehäuse 2, als auch der Tragring 3 besonders dünne Wandstärken aufweisen, kann der Fortsatz des Gehäuses 2, ohne das Design zu beeinträchtigen der Wandfläche zugeordnet werden.

Über zwei erste Schrauben 11 werden die beiden Halteplatten 8 und damit die Domschaltmatte DS und die erste Leiterplatte L1 sowie die zweite Leiterplatte L2 auf dem Tragring 3 befestigt, dazu greifen die ersten Schrauben 11 in Gewinde des Tragringes 3 ein. Zwei zweite Schrauben 12 sind dafür vorgesehen, jeweils ein als Schwenkarm ausgebildetes Riegelelement zu betätigen, um somit das unbefugte Entfernen des elektrischen/elektronischen Installationsgerätes aus er Installationsdose D wirkungsvoll zu verhindern.

## Patentansprüche

1. Elektrisches/elektronisches Installationsgerät für die Gebäudesystemtechnik mit einer ersten Leiterplatte (L1) auf dessen Oberseite alle zur Bedienung notwendigen Funktionselemente angeordnet sind, wobei auf der Unterseite ein- und derselben ersten Leiterplatte (L1) sowohl die für die jeweilige Applikation notwendigen, als auch ein erster Teil der für den Betrieb in einem Bussystem notwendigen Funktionsbauteile (4) angeordnet sind, und wobei die erste Leiterplatte (L1) elektrisch leitend mit einer zweiten Leiterplatte (L2) in Verbindung steht, auf welcher der zweite Teil der für den Betrieb im Bussystem notwenigen Funktionsbauteile (4) angeordnet sind, und wobei der Oberseite der ersten Leiterplatte (L1) eine Anzeigeeinrichtung (LCM) zugeordnet ist, **dadurch gekennzeichnet, dass** die der Oberseite der ersten Leiterplatte (L1) zugeordnete Anzeigeeinrichtung (LCM) samt der zweiten Leiterplatte (L2) und der ersten Leiterplatte (L1) an einem Gehäuse (2) festgelegt ist, und dass die erste Leiterplatte (L1), und das die erste Leiterplatte (L1) aufnehmende Gehäuse (2) an zumindest einer Seite jeweils einen Fortsatz (FL, FG) aufweisen, und dass das Gehäuse (2) mit der ebenen Unterseite seines Fortsatz (FG) auf der Wandfläche einer die Installationsdose (D) aufnehmenden Wand zur Anlage kommt, und dass die Oberseite des Fortsatz (FL) der ersten Leiterplatte (L1) zur Anordnung von zur Bedienung notwendigen Funktionselementen vorgesehen ist.

2. Elektrisches/elektronisches Installationsgerät nach Anspruch 1, **dadurch gekennzeichnet, dass** die Schaltflächen (5) der zur Bedienung notwendigen Schaltelemente (6) matrixartig auf der Oberseite der ersten Leiterplatte (L1) angeordnet sind.

3. Elektrisches/elektronisches Installationsgerät nach Anspruch 1 oder 2, **dadurch gekennzeichnet, dass** zumindest ein auf der Oberseite der ersten Leiterplatte (L1) angeordnetes Schaltelement (6) als Domschaltelement ausgeführt ist.

4. Elektrisches/elektronisches Installationsgerät nach einem der Ansprüche 1 bis 3, **dadurch gekennzeichnet, dass** alle auf der Oberseite der ersten Leiterplatte (L1) angeordneten Schaltelemente (6) einstückig Bestandteil einer einzigen Domschaltmatte (DS) sind.

5. Elektrisches/elektronisches Installationsgerät nach einem der Ansprüche 1 bis 4, **dadurch gekennzeichnet, dass** zumindest einer auf der Oberseite der ersten Leiterplatte (L1) angeordneten Schaltflächen (5) zumindest ein als Leuchtdiode (LED) ausgebildetes Funktionselement zugeordnet ist.

6. Elektrisches/elektronisches Installationsgerät nach einem der Ansprüche 1 bis 5, **dadurch gekennzeichnet, dass** zumindest ein auf der Unterseite der ersten Leiterplatte (L1) angeordnetes Funktionsbauteil als Speicher für die Anwendungssoftware ausgeführt ist.

7. Elektrisches/elektronisches Installationsgerät nach einem der Ansprüche 1 bis 6, **dadurch gekennzeichnet, dass** zumindest ein auf der Unterseite der ersten Leiterplatte (L1) angeordnetes Funktionsbauteil als Steckanschluss ausgeführt ist.

8. Elektrisches/elektronisches Installationsgerät nach einem der Ansprüche 1 bis 7, **dadurch gekennzeichnet, dass** die erste Leiterplatte (L1) und die zweite Leiterplatte (L2) gemeinsamen von einem Gehäuse (2) aufgenommen sind.

9. Elektrisches/elektronisches Installationsgerät nach Anspruch 8, **dadurch gekennzeichnet, dass** dem Gehäuse (2) ein Tragring (3) zugeordnet ist.

10. Elektrisches/elektronisches Installationsgerät nach Anspruch 7 oder 8, **dadurch gekennzeichnet, dass** dem Gehäuse (2) als Haltefedern (10) ausgebildete Befestigungsmittel für die Installation zugeordnet sind.

11. Elektrisches/elektronisches Installationsgerät nach einem der Ansprüche 1 bis 10, **dadurch gekennzeichnet, dass** zumindest eines der, der Oberseite der ersten Leiterplatte (L1) zugeordneten Funktionselemente als Lichtleitkörper (7) ausgebildet ist.

12. Elektrisches/elektronisches Installationsgerät nach einem der Ansprüche 1 bis 11, **dadurch gekennzeichnet, dass** zumindest eines der, der Oberseite der ersten Leiterplatte (L1) zugeordneten Funktionselemente als Halteplatte (8) ausgeführt ist

13. Elektrisches/elektronisches Installationsgerät nach einem der Ansprüche 1 bis 12, **dadurch gekennzeichnet, dass** zumindest eines der, der Oberseite der ersten Leiterplatte (L1) zugeordneten Funktionselemente als Betätigungstaste (9) ausgeführt ist.

14. Elektrisches/elektronisches Installationsgerät nach einem der Ansprüche 1 bis 13, **dadurch gekennzeichnet, dass** zumindest eines der, der Oberseite der ersten Leiterplatte (L1) zugeordneten Funktionselemente als sensorische Anordnung ausgeführt ist.

15. Elektrisches/elektronisches Installationsgerät nach einem der Ansprüche 1 bis 14, **dadurch gekennzeichnet, dass** zumindest ein Bereich der Oberfläche der Anzeigeeinrichtung (LCM) sensorische Eigenschaften aufweist.

16. Elektrisches/elektronisches Installationsgerät nach einem der Ansprüche 1 bis 15, **dadurch gekennzeichnet, dass** die Anzeigeeinrichtung (LCM) als Flüssigkeitskristallmodul ausgeführt ist.

17. Elektrisches/elektronisches Installationsgerät nach einem der Ansprüche 1 bis 16, **dadurch gekennzeichnet, dass** der Anzeigeeinrichtung (LCM) eine beführungsempfindliche Folie zugeordnet ist.

18. Elektrisches/elektronisches Installationsgerät nach einem der Ansprüche 1 bis 17, **dadurch gekennzeichnet, dass** der untere Teil des Gehäuses (2), welcher die erste Leiterplatte (L1) mit ihren auf der Unterseite angeordneten Funktionsbauteilen und die Unterseite der zweiten Leiterplatte (L2) umgibt, derartige Außenabmessungen aufweist, dass die Einführung in den Innenraum (I) einer normalen Installationsdose (D) möglich ist.

## Claims

1. Electrical/electronic installation device for building systems engineering purposes with a first printed circuit board (L1) on the top surface of which all the functional components for operation are located, with the functional components (4) needed for the respective application as well as the first portion of the functional components (4) necessary for operating in a bus system being located on the bottom surface of the same first printed circuit board (L1), and with the first printed circuit board (L1) being conductively connected to a second printed circuit board (L2) on which the second portion of the functional components (4) needed for operating in the bus system are located, and with a display facility (LCM) being attached to the top surface of the first printed circuit board (L1), **characterised in that** the display facility (LCM) attached to the top surface of the first printed circuit board (L1) is allocated, together with the second printed circuit board (L2) and the first printed circuit board (L1), to a housing (2) and that the first printed circuit board (L1) and the housing (2) accommodating the first printed circuit board (L1) each feature an appendage (FL, FG) on at least one side, and that the housing (2) comes to rest with the flat underside of its appendage (FG) on the wall surface of a wall accommodating the installation box (D) and that the upper side of the appendage (FL) of the first printed circuit board (L1) is provided for locating functional elements needed for operation.

2. Electrical/electronic installation device according to Claim 1, **characterised in that** the push buttons (5) of the switching elements (6) required for operation are arranged matrix-like on the top surface of the first printed circuit board (L1).

3. Electrical/electronic installation device according to Claim 1 or Claim 2, **characterised in that** at least one switching element (6) located on the top surface of the first printed circuit board (L1) is designed as a dome-switch element.

4. Electrical/electronic installation device according to any of Claims 1 to 3, **characterised in that** all the switching elements (6) located on the top surface of the first printed circuit board (L1) are an integral element of a single dome switch mat (DS).

5. Electrical/electronic installation device according to any of Claims 1 to 4, **characterised in that** at least one functional component designed as a light-emitting diode (LED) is attached to at least one of the push buttons (5) located on the top surface of the first printed circuit board (L1).

6. Electrical/electronic installation device according to any of Claims 1 to 5, **characterised in that** at least one functional component located on the bottom surface of the first printed circuit board (L1) is designed as a memory for the application software.

7. Electrical/electronic installation device according to any of Claims 1 to 6, **characterised in that** at least one functional component located on the bottom surface of the first printed circuit board (L1) is designed as a plug-and-socket connection.

8. Electrical/electronic installation device according to any of Claims 1 to 7, **characterised in that** the first printed circuit board (L1) and the second printed circuit board (L2) are collectively retained by a housing (2).

9. Electrical/electronic installation device according to Claim 8, **characterised in that** a supporting ring (3) is attached to the housing (2).

10. Electrical/electronic installation device according to Claim 7 or Claim 8, **characterised in that** fasteners designed as retention springs (10) are attached to the housing (2) for installation purposes.

11. Electrical/electronic installation device according to any of Claims 1 to 10, **characterised in that** at least one of the functional components attached to the top surface of the first printed circuit board (L1) is designed as a light guide element (7).

12. Electrical/electronic installation device according to any of Claims 1 to 11, **characterised in that** at least one of the functional components attached to the top surface of the first printed circuit board (L1) is designed as a retaining plate (8).

13. Electrical/electronic installation device according to any of Claims 1 to 12, **characterised in that** at least one of the functional components attached to the top surface of the first printed circuit board (L1) is designed as an operating key (9).

14. Electrical/electronic installation device according to any of Claims 1 to 13, **characterised in that** at least one of the functional components attached to the top surface of the first printed circuit board (L1) is designed as a sensor array.

15. Electrical/electronic installation device according to any of Claims 1 to 14, **characterised in that** at least one section of the surface of the display facility (LCM) shows sensory properties.

16. Electrical/electronic installation device according to any of Claims 1 to 15, **characterised in that** the display facility (LCM) is designed as a liquid crystal module.

17. Electrical/electronic installation device according to any of Claims 1 to 16, **characterised in that** a pressure-sensitive foil is allocated to the display facility (LCM).

18. Electrical/electronic installation device according to any of Claims 1 to 17, **characterised in that** the lower section of the housing (2), which encompasses the first printed circuit board (L1) with its functional components located on the bottom surface and the bottom surface of the second printed circuit board (L2), features outer dimensions so as to enable its insertion into the interior (I) of a standard installation box (D).

## Revendications

1. Appareil d'installation électrique/électronique pour les installations techniques systémiques des bâtiments et la domotique avec une première carte à circuits imprimés (L1) sur le côté supérieur duquel sont placés tous les éléments fonctionnels nécessaires à la commande, étant placés sur le côté inférieur de cette même carte à circuits imprimés (L1) aussi bien les éléments fonctionnels nécessaires à l'application respective qu'une première partie des éléments fonctionnels nécessaires au fonctionnement dans un système de bus (4), et la première carte à circuits imprimés (L1) étant en relation conductrice d'électricité avec une seconde carte à circuits imprimés (L2), sur laquelle est placée la deuxième partie des éléments fonctionnels nécessaires au fonctionnement dans un système de bus (4), et un dispositif d'affichage (LCM) étant attribué au côté supérieur de la première carte à circuits imprimés (L1), **caractérisé en ce que** le dispositif d'affichage (LCM) attribué au côté supérieur de la première carte à circuits imprimés (L1) est fixé avec la seconde carte à circuits imprimés (L2) et la première carte à circuits imprimés (L1) à un boîtier (2), et **en ce que** la première carte à circuits imprimés (L1) et le boîtier (2) accueillant la première carte à circuits imprimés (L1) présentent d'un côté au moins un prolongement (FL, FG), et **en ce que** le boîtier (2) vient s'appuyer par le dessous plan de son prolongement (FG) à la surface d'un mur accueillant la boîte d'installation (D), et **en ce que** le côté supérieur du prolongement (FL) de la première carte à circuits imprimés (L1) est prévu pour l'emplacement d'éléments fonctionnels nécessaires à la commande.

2. Appareil d'installation électrique/électronique selon la revendication 1, **caractérisé en ce que** les surfaces de commutation (5) des éléments de commutation (6) nécessaires à la commande sont placées en tableau sur le côté supérieur de la première carte à circuits imprimés (L1).

3. Appareil d'installation électrique/électronique selon la revendication 1 ou 2, **caractérisé en ce que** au moins l'un des éléments de commutation (6) situés sur le côté supérieur de la première carte à circuits imprimés (L1) est réalisé sous forme de minirupteurs ou de minitouches.

4. Appareil d'installation électrique/électronique selon l'une des revendications 1 à 3, **caractérisé en ce que** l'ensemble des éléments de commutation (6) situés sur le côté supérieur de la première carte à circuits imprimés (L1) font partie en une pièce d'un seul bloc de minirupteurs ou de minitouches (DS).

5. Appareil d'installation électrique/électronique selon l'une des revendications 1 à 4, **caractérisé en ce que** au moins un élément fonctionnel, sous forme de diode électroluminescente (LED), est attribué à au moins une surface de commutation (5) située sur le côté supérieur de la première carte à circuits imprimés (L1).

6. Appareil d'installation électrique/électronique selon l'une des revendications 1 à 5, **caractérisé en ce que** au moins un élément fonctionnel situé sur le côté inférieur de la première carte à circuits imprimés (L1) est réalisé sous forme de mémoire pour le logiciel d'application.

7. Appareil d'installation électrique/électronique selon l'une des revendications 1 à 6, **caractérisé en ce que** au moins un élément fonctionnel situé sur le côté inférieur de la première carte à circuits imprimés (L1) est réalisé sous forme de connecteur emboîtable ou à fiche.

8. Appareil d'installation électrique/électronique selon l'une des revendications 1 à 7, **caractérisé en ce que** la première carte à circuits imprimés (L1) et la seconde carte à circuits imprimés (L2) sont accueillies ensemble par un boîtier (2).

9. Appareil d'installation électrique/électronique selon la revendication 8, **caractérisé en ce que** un anneau support (3) est attribué au boîtier (2).

10. Appareil d'installation électrique/électronique selon la revendication 7 ou 8, **caractérisé en ce que** sont attribués au boîtier (2) des pièces de fixation de l'installation, réalisées sous forme de ressorts de retenue et de maintien (10).

11. Appareil d'installation électrique/électronique selon l'une des revendications 1 à 10, **caractérisé en ce que** au moins l'un des éléments fonctionnels attribués au côté supérieur de la première carte à circuits imprimés (L1) est réalisé sous forme d'élément de guidage de la lumière (7).

12. Appareil d'installation électrique/électronique selon l'une des revendications 1 à 11, **caractérisé en ce que** au moins l'un des éléments fonctionnels attribués au côté supérieur de la première carte à circuits imprimés (L1) est réalisé sous forme de plaque support (8).

13. Appareil d'installation électrique/électronique selon l'une des revendications 1 à 12, **caractérisé en ce que** au moins l'un des éléments fonctionnels attribués au côté supérieur de la première carte à circuits imprimés (L1) est réalisé sous forme de touche d'actionnement (9).

14. Appareil d'installation électrique/électronique selon l'une des revendications 1 à 13, **caractérisé en ce que** au moins l'un des éléments fonctionnels attribués au côté supérieur de la première carte à circuits imprimés (L1) est réalisé sous forme de groupe de capteurs.

15. Appareil d'installation électrique/électronique selon l'une des revendications 1 à 14, **caractérisé en ce que** au moins une zone de la surface du dispositif d'affichage (LCM) présente des propriétés de capteurs.

16. Appareil d'installation électrique/électronique selon l'une des revendications 1 à 15, **caractérisé en ce que** le dispositif d'affichage (LCM) est réalisé sous forme de module à cristaux liquides.

17. Appareil d'installation électrique/électronique selon l'une des revendications 1 à 16, **caractérisé en ce que** un film sensible au toucher est attribué au dispositif d'affichage (LCM).

18. Appareil d'installation électrique/électronique selon l'une des revendications 1 à 17, **caractérisé en ce que** la partie inférieure du boîtier (2) entourant la première carte à circuits imprimés (L1) avec ses éléments fonctionnels situés sur le côté inférieur, et le côté inférieur de la seconde carte à circuits imprimés (L2), est de dimensions extérieures telles qu'elle permet l'introduction dans la cavité intérieure (I) d'une boîte d'installation normale (D).
